(19) **Europäisches Patentamt / European Patent Office / Office européen des brevets**

(11) **EP 4 644 889 A1**

(12) **EUROPÄISCHE PATENTANMELDUNG**

(43) Veröffentlichungstag:
05.11.2025 Patentblatt 2025/45

(21) Anmeldenummer: 24173848.3

(22) Anmeldetag: 02.05.2024

(51) Internationale Patentklassifikation (IPC):
*G01N 24/00* (2006.01)  *G01R 33/26* (2006.01)

(52) Gemeinsame Patentklassifikation (CPC):
**G01N 24/006; G01R 33/26**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(71) Anmelder: **Fraunhofer-Gesellschaft zur Förderung der angewandten Forschung e.V. 80686 München (DE)**

(72) Erfinder:
• **Koss, Peter**
  **79110 Freiburg im Breisgau (DE)**
• **Blug, Andreas**
  **79110 Freiburg im Breisgau (DE)**
• **Schwarzer, Stefan**
  **79110 Freiburg im Breisgau (DE)**
• **Rasser, Ronja**
  **79110 Freiburg im Breisgau (DE)**
• **Laux, Patrick**
  **79110 Freiburg im Breisgau (DE)**

(74) Vertreter: **WSL Patentanwälte Partnerschaft mbB Kaiser-Friedrich-Ring 98 65185 Wiesbaden (DE)**

(54) **SYSTEM ZUM ORTSAUFGELÖSTEN ERFASSEN EINES MASSES FÜR DIE MAGNETISCHE FLUSSDICHTE EINES MAGNETISCHEN STREUFELDS AN DER OBERFLÄCHE EINES PRÜFOBJEKTS**

(57)    Die vorliegende Erfindung betrifft ein System zum ortsaufgelösten Erfassen eines Maßes für die magnetische Flussdichte eines magnetischen Streufelds an der Oberfläche eines Prüfobjekts. Das erfindungsgemäße System umfasst eine Strahlungsquelle, ein magnetfeldsensitives Medium, eine magnetische Abschirmung mit einem abgeschirmten Volumen, eine Beleuchtungsoptik, ein reflektierendes Element, einen digitalen Bildsensor, eine Abbildungsoptik und eine Steuer- und Auswerteeinrichtung.

Fig. 1

EP 4 644 889 A1

**Beschreibung**

Die vorliegende Erfindung betrifft ein System zum ortsaufgelösten Erfassen eines Maßes für die magnetische Flussdichte eines magnetischen Streufelds an der Oberfläche eines Prüfobjekts.

Zur zerstörungsfreien Prüfung eines Prüfobjekts kann das magnetische Streufeld an seiner Oberfläche herangezogen werden. Bei jeder Umformung eines Werkstücks, einschließlich der Urformung des Werkstücks, werden zwangsläufig lokale Spannungskonzentrationen in das Werkstück eingebracht. Anschauliche Beispiele dafür sind ein Umformen, beispielsweise durch spanende Bearbeitung, oder ein Fügen des Werkstücks, beispielsweise durch Schweißen. Wird das fertige Bauteil während seiner Verwendung belastet, so sorgen die Spannungskonzentrationen dafür, dass lokal bruchmechanische Schwellenwerte für die Ausbildung von Anrissen, wie z.B. die Fließ- oder Spaltbruchgrenze, erreicht und gegebenenfalls überschritten werden. Die lokale Spannung im Bauteil überlagert sich dabei mit der thermischen oder mechanischen Spannung aufgrund der Verwendung des Bauteils. Daher führen die durch die Umformung hervorgerufenen lokalen Spannungskonzentrationen im Laufe der späteren Beanspruchung des Bauteils bei seinem Gebrauch zur Ausbildung von Anrissen und somit irgendwann zum Versagen des Bauteils.

Wünschenswert ist es daher, Bereiche eines Werkstücks mit lokalen Spannungskonzentrationen oder (Vor-)Schädigungen frühzeitig zu erfassen und entweder ein Werkstück gar nicht erst als Bauteil auszuliefern oder das Bauteil vor seinem Versagen zu wechseln. Die räumliche Verteilung des magnetischen Streufelds eines solchen Bauteils ist somit ein Maß für die räumliche Verteilung lokaler, mechanischer Spannungskonzentrationen in dem Bauteil. Daher gibt es eine Reihe von Verfahren und Systemen zum ortsaufgelösten Erfassen des magnetischen Streufelds an der Oberfläche eines Prüflings.

Den aus dem Stand der Technik bekannten Systemen ist gemein, dass sie das magnetische Streufeld an der Oberfläche des Prüfobjekts zeitlich nacheinander an einer Mehrzahl von Objektpunkten abtasten. Die bekannten Systeme arbeiten scannend.

Demgegenüber ist es die Aufgabe der vorliegenden Erfindung, ein System bereitzustellen, welches gleichzeitig eine Mehrzahl von Bildpunkten des magnetischen Streufelds an der Oberfläche eines Prüfobjekts erfasst. Es ist zudem eine Aufgabe der vorliegenden Erfindung, ein System bereitzustellen, das kostengünstig und effizient ist. Ferner ist eine Aufgabe der Erfindung, ein System bereitzustellen, das magnetische Streufeld mit der erforderlichen Empfindlichkeit erfasst.

Zumindest eine der zuvor genannten Aufgaben wird durch ein System zum ortsaufgelösten Erfassen eines Maßes für die magnetische Flussdichte eines magnetischen Streufelds an der Oberfläche eines Prüfobjekts gemäß dem unabhängigen Anspruch 1 gelöst. Dazu weist das System die folgenden Bestandteile auf: eine Strahlungsquelle, ein magnetfeldsensitives Medium, eine magnetische Abschirmung, eine Beleuchtungsoptik, ein reflektierendes Element, einen digitalen Bildsensor, eine Abbildungsoptik sowie eine Steuer- und Auswerteeinrichtung.

Erfindungsgemäß ist die Strahlungsquelle derart ausgestaltet und angeordnet, dass die Strahlungsquelle in dem Betrieb des Systems elektromagnetische Pumpstrahlung und elektromagnetische Abfragestrahlung erzeugt und abstrahlt.

In einer Ausführungsform der Erfindung unterscheiden sich die Pumpstrahlung und die Abfragestrahlung nur in zeitlicher Hinsicht, da die Pumpstrahlung zuerst in das magnetfeldsensitive Medium eingestrahlt wird, um dieses optisch zu pumpen, und die Abfragestrahlung wird danach in das magnetfeldsensitive Medium eingestrahlt, um die aufgrund des Streufelds mit der Larmorfrequenz modulierte Absorption abzufragen. In einer Ausführungsform jedoch unterscheidet sich die Pumpstrahlung von der Abfragestrahlung aufgrund ihrer Intensität. In einer Ausführungsform der Erfindung ist die Abfrageintensität geringer als die Pumpintensität. Dabei ist die Abfrageintensität in einer Ausführungsform so gewählt, dass die Spins in dem magnetfeldsensitiven Medium frei mit der Larmorfrequenz präzedieren können.

In einer Ausführungsform ist die Strahlungsquelle ein Laser, vorzugsweise ein Dauerstrichlaser.

Das magnetfeldsensitive Medium ist erfindungsgemäß derart ausgestaltet, dass es in dem Betrieb des Systems nach einem optischen Pumpen mit der Pumpstrahlung eine Spinpräzession mit einer von dem Streufeld abhängigen Larmorfrequenz ermöglicht.

Gemäß einer Ausführungsform der vorliegenden Erfindung ist das magnetfeldsensitive Medium ein Gas oder ein Dampf. Insbesondere ist das magnetfeldsensitive Medium in einer Ausführungsform ein Dampf mit Alkaliatomen, vorzugsweise mit Rubidium-Atomen, Cäsium-Atomen oder Kalium-Atomen, oder ein Gas mit Helium-4-Atomen. Ein Dampf mit Rubidium-Atomen wird bei einer Wellenlänge der Pumpstrahlung von etwa 795 nm gepumpt. Ein Dampf mit Cäsium-Atomen wird bei einer Wellenlänge der Pumpstrahlung von etwa 894 nm gepumpt. Bei diesen Wellenlängen wird typischerweise der D1-Übergang der Atome gepumpt.

In einer Ausführungsform wird die freie Spinpräzession bei oder nach Abschluss des jeweiligen Pumpzeitraums durch Anlegen eines Startsignals an die Messzelle angestoßen.

Zum Anstoßen der freien Spinpräzession wird in einer Ausführungsform die Abfragestrahlung als Startsignal verwendet, indem der Abfragestrahlung eine Amplitudenmodulation, eine Frequenzmodulation oder eine Phasenmodulation mit einer Modulationsfrequenz aufgeprägt wird. Dabei ist in einer Ausführungsform die Modulationsfrequenz gleich der Larmorfrequenz des magnetfeldsensitiven Mediums.

In einer weiteren Ausführungsform wird die freie Spinpräzession mit einem elektromagnetischen Impuls als Startsignal angestoßen, wobei der elektromagnetische Impuls eine Trägerfrequenz aufweist. Dieser elektromagnetische Impuls wird an eine Messzelle angelegt, in welcher der Dampf aufgenommen ist. Die Trägerfrequenz dieses elektromagnetischen Impulses liegt in einer Ausführungsform im Radiofrequenzbereich. In einer Ausführungsform liegt die Trägerfrequenz in einem Bereich von plus/minus 10% um die Larmorfrequenz des magnetfeldsensitiven Mediums herum. In einer Ausführungsform der Erfindung ist die Trägerfrequenz gleich der Larmorfrequenz.

In einer weiteren Ausführungsform der Erfindung ist der Dampf in einer Messzelle aufgenommen, wobei die Messzelle vorzugsweise beheizbar ist. In einer Ausführungsform weist die Messzelle der Strahlrichtung der Abfragestrahlung eine Dicke von 500 $\mu$m oder weniger auf.

In einer Ausführungsform wird die Messzelle in Abhängigkeit der verwendeten Atome auf eine Temperatur in einem Bereich von 20 Grad Celsius bis 200 Grad Celsius erhitzt. Der Gasdruck des Rubidium enthaltenden Dampfs liegt in einem Bereich von $1,5*10^5$ Pa und $2,5*10^5$ Pa.

Die Messzelle besteht in einer Ausführungsform aus drei Teilen: zwei Glasdeckeln oben und unten und einem Abstandshalter aus Silizium zwischen den Glasdeckeln. Die Dicke der Messzelle wird durch die Dicke des Siliziums definiert. Die Glasdeckel dienen als Messfenster für die Pumpstrahlung und die Abfragestrahlung.

Um die erforderlichen Zelltemperaturen zu erreichen, wird die Messzelle in einer Ausführungsform mit einer elektrischen Widerstandsheizung geheizt. Ein Heizwiderstand auf den Glasdeckeln wird während der Pumpzeiträume geschaltet, um nur dann zu heizen. Nach dem jeweiligen Pumpzeitraum wird der Strom im Heizwiderstand ausgeschaltet, um Störfelder zu vermeiden. Die Zelle ist thermisch isoliert, um die erforderliche Heizleistung zu reduzieren.

Die magnetische Abschirmung umfasst erfindungsgemäß ein abgeschirmtes Volumen, eine Eintrittsöffnung für die Pumpstrahlung und die Abfragestrahlung in das abgeschirmte Volumen, eine Austrittsöffnung für die Abfragestrahlung aus dem abgeschirmten Volumen und eine Magnetfeldöffnung für das Streufeld. Dabei ist die Strahlungsquelle außerhalb des abgeschirmten Volumens der magnetischen Abschirmung angeordnet und das magnetfeldsensitive Medium ist innerhalb des abgeschirmten Volumens angeordnet, sodass das Streufeld in dem Betrieb des Systems das magnetische Medium durchsetzen kann.

Die magnetische Abschirmung besteht in einer Ausführungsform der Erfindung aus einem weichmagnetischen Metall mit hoher magnetischer Permeabilität, beispielsweise mit einer weichmagnetischen Nickel-Eisen-Legierung mit 72 bis 80 % Nickel sowie Anteilen von Kupfer, Molybdän, Kobalt oder Chrom, d.h. einem Mu-Metall.

Die Beleuchtungsoptik ist erfindungsgemäß derart ausgestaltet und angeordnet, dass sie in dem Betrieb des Systems eine Messfläche des magnetfeldsensitiven Mediums mit der von der Strahlungsquelle erzeugten Pumpstrahlung und Abfragestrahlung beleuchtet.

Das reflektierende Element ist erfindungsgemäß derart in einer Strahlrichtung der Abfragestrahlung hinter dem magnetfeldsensitiven Medium angeordnet, dass es die Abfragestrahlung zurück in das magnetfeldsensitive Medium und durch die Austrittsöffnung aus dem abgeschirmten Volumen reflektiert. In einer Ausführungsform der Erfindung ist das reflektierende Element eine metallische Schicht, insbesondere eine metallische Schicht aus einem nicht ferromagnetischen Material, oder ein dielektrischer Spiegel für die Wellenlänge der Pumpstrahlung und der Abfragestrahlung.

Der digitale Bildsensor umfasst erfindungsgemäß eine Mehrzahl von Pixeln, eine mit der Mehrzahl von Pixeln verbundene Ausleseelektronik, einen mit der Ausleseelektronik verbundenen Analog-Digital-Umsetzer und einen Signalausgang. Dabei ist der digitale Bildsensor derart eingerichtet, dass in dem Betrieb des Systems an dem Signalausgang ein digitales Bildsignal ausgegeben wird. Auch der Bildsensor ist erfindungsgemäß außerhalb des abgeschirmten Volumens angeordnet.

Erfindungsgemäß ist die Abbildungsoptik derart ausgestaltet und angeordnet, dass die Abbildungsoptik in dem Betrieb des Systems die Abfragestrahlung von jedem aus einer Mehrzahl von Objektpunkten in der Messfläche durch die Austrittsöffnung auf jeweils ein Pixel des Bildsensors abbildet.

Die Steuer- und Auswerteeinrichtung ist gemäß der Erfindung derart wirksam mit der Strahlungsquelle verbunden, dass die Strahlungsquelle in dem Betrieb des Systems ein Quellensteuersignal von der Steuer- und Auswerteeinrichtung empfängt. Zudem ist die Steuer- und Auswerteeinrichtung derart wirksam mit dem Signalausgang verbunden, dass die Steuer- und Auswerteeinrichtung in dem Betrieb des Systems das Bildsignal von dem Bildsensor empfängt. Zudem ist die Steuer- und Auswerteeinrichtung derart eingerichtet, dass die Steuer- und Auswerteeinrichtung in dem Betrieb des Systems die Schritte ausführt:

- Erzeugen des Quellensteuersignals derart, dass die Strahlungsquelle das magnetfeldsensitive Medium über einen Pumpzeitraum mit der Pumpstrahlung mit einer Pumpintensität beleuchtet und über einen an den Pumpzeitraum anschließenden Abfragezeitraum mit der Abfragestrahlung mit einer Abfrageintensität beleuchtet,
- während des Abfragezeitraums für jeden aus der Mehrzahl von Pixeln Berechnen der Larmorfrequenz des zu dem jeweiligen Pixel gehörenden Objektpunkts aus einem zeitlichen Verlauf des Bildsignals und
- Ausgeben der Larmorfrequenz für jedes Pixel als das Maß für das magnetische Streufeld des Prüfobjekts.

Es ist die grundlegende Idee der vorliegenden Erfindung, das magnetische Streufeld ortsaufgelöst für eine Mehrzahl von Messpunkten an der Oberfläche des Prüfobjekts gleichzeitig durch Bestimmen der Larmorfrequenz einer sogenannten freien Spinpräzession (FSP) in dem von dem Streufeld durchsetzten magnetfeldsensitiven Medium zu erfassen.

Die Erfassung der Spinpräzession erfolgt optisch, indem das mit der Pumpstrahlung gepumpte magnetfeldsensitive Medium nach dem Pumpen mit der Abfragestrahlung beleuchtet wird und die mit der Larmorfrequenz modulierte Absorption der Abfragestrahlung in dem magnetfeldsensitiven Medium ortsaufgelöst erfasst wird.

Die Messung der Larmorfrequenz während der freien Spinpräzession bietet den Vorteil, dass es sich um eine reine Frequenzmessung handelt, die in Bildfolgen für jeden einzelnen Bildpunkt unabhängig von anderen Messpunkten und ohne homodynes Mischen von Pump- und Messsignal ausgewertet werden kann.

Erfindungsgemäß erfolgt dieses Erfassen der Spinpräzession des magnetfeldsensitiven Mediums zeitlich parallel für eine Mehrzahl von Objektpunkten in der Messfläche des magnetfeldsensitiven Mediums. Für dieses parallele Erfassen wird ein digitaler Bildsensor verwendet. Ein solcher digitaler Bildsensor wird umgangssprachlich auch als Digitalkamera bezeichnet. Derartige digitale Bildsensoren sind in verschiedenen Ausführungsformen, beispielsweise als CCD-Kameras oder CMOS-Kameras, kommerziell erhältlich und entsprechend kostengünstig.

Das System benötigt zum ortsaufgelösten Erfassen eines Maßes für die magnetische Flussdichte des magnetischen Streufelds eine Empfindlichkeit von weniger als einem Nanotesla. Da das zu messende Streufeld kleiner ist als die Störungen durch das Erdmagnetfeld, gilt es, das magnetfeldsensitive Medium mit der magnetischen Abschirmung abzuschirmen. Daher ist das magnetfeldsensitive Medium in dem abgeschirmten Volumen der magnetischen Abschirmung angeordnet. Eine Magnetfeldöffnung ist derart angeordnet, dass das Streufeld von der Oberfläche des Prüfobjekts das magnetfeldsensitive Medium durchsetzen kann.

Im Gegensatz zu Photodioden, die mit sehr kleinen Strömen betrieben werden können, erzeugen digitale Bildsensoren, insbesondere schnelle Kameras mit Übertragungsraten von 1 GB/s und mehr sehr, starke Störfelder. Das zu messende Streufeld ist um Größenordnungen kleiner als die Störfelder des digitalen Bildsensors, so wie er erfindungsgemäß zum Einsatz kommt. Daher ist der digitale Bildsensor außerhalb der magnetischen Abschirmung angeordnet. Ähnliches gilt für die Strahlungsquelle, insbesondere für deren Treiberelektronik.

Das Anordnen der Strahlungsquelle und des digitalen Bildsensors außerhalb des abgeschirmten Volumens der magnetischen Abschirmung führt aber dazu, dass in der magnetischen Abschirmung zusätzlich zu der Magnetfeldöffnung eine Eintrittsöffnung für die Pumpstrahlung und die Abfragestrahlung und eine Austrittsöffnung zumindest für die Abfragestrahlung vorgesehen sein muss.

In einer Ausführungsform der Erfindung sind der Strahlengang der Pumpstrahlung und der Strahlengang der Abfragestrahlung identisch. Dies erleichtert die Konzeption der Beleuchtungsoptik.

In einer Ausführungsform der Erfindung ist die Beleuchtungsoptik zumindest auch innerhalb des abgeschirmten Volumens der magnetischen Abschirmung angeordnet. In einer Ausführungsform der Erfindung ist die Abbildungsoptik zumindest auch außerhalb des abgeschirmten Volumens der magnetischen Abschirmung angeordnet.

In einer Ausführungsform der Erfindung umfasst die Beleuchtungsoptik eine optische Faser, welche durch die Eintrittsöffnung in der magnetischen Abschirmung in das abgeschirmte Volumen geführt ist und durch welche die Pumpstrahlung und die Abfragestrahlung geleitet werden.

Alle Öffnungen in der magnetischen Abschirmöffnung, so auch die Eintrittsöffnung und die Austrittsöffnung, reduzieren die Abschirmwirkung der magnetischen Abschirmung. Daher sind die Öffnungen so klein wie möglich auszugestalten.

In einer Ausführungsform der Erfindung ist daher die Abbildungsoptik derart ausgestaltet, dass eine Fläche der Austrittsöffnung sowohl kleiner ist als eine Fläche einer Mehrzahl von Pixeln des Bildsensors als auch kleiner ist als die Messfläche des magnetfeldsensitiven Mediums.

In einer Ausführungsform der Erfindung weist die Abbildungsoptik eine erste Linsenanordnung und eine zweite Linsenanordnung auf, wobei die erste Linsenanordnung in der Strahlrichtung der Abfragestrahlung nach dem magnetfeldsensitiven Medium und innerhalb des abgeschirmten Volumens angeordnet ist, wobei die zweite Linsenanordnung in der Strahlrichtung der Abfragestrahlung nach der ersten Linsenanordnung und außerhalb des abgeschirmten Volumens angeordnet ist und wobei die erste Linsenanordnung und die zweite Linsenanordnung derart ausgestaltet und angeordnet sind, dass sie ein telezentrisches Objektiv für die Messfläche bilden.

Bei einem solchen telezentrischen Objektiv liegt die bildseitige Pupille, d.h. das Bild der Blende im kameraseitigen Strahlengang, in der Blickrichtung der Kamera betrachtet in Strahlrichtung hinter dem magnetfeldsensitiven Medium, vorzugsweise deutlich hinter dem magnetfeldsensitiven Medium und besonders bevorzugt im Unendlichen hinter dem magnetfeldsensitiven Medium.

Um eine einfache Realisierung eines solchen telezentrischen Objektivs zu ermöglichen, ist in einer Ausführungsform der Erfindung die Beleuchtungsoptik derart ausgestaltet, dass die Abbildungsstrahlung senkrecht auf die Messfläche des magnetfeldsensitiven Mediums trifft. Die Abfragestrahlung ist kollimiert.

Eine telezentrische Anordnung aus der ersten und der zweiten Linsenanordnung der Abbildungsoptik führt auch dazu, dass die Brennweite der ersten Linsenanordnung in die Austrittsöffnung der magnetischen Abschirmung gelegt werden kann. Auf diese Weise kann die Fläche der Austrittsöffnung minimiert werden und trotzdem eine Mehrzahl von Objektpunkten in der Messfläche gleichzeitig auf die Mehrzahl von Pixeln des digitalen Bildsensors außerhalb des abgeschirmten Volumens der magnetischen Abschirmung abgebildet werden.

In einer Ausführungsform der Erfindung sind die erste Linsenanordnung und die zweite Linsenanordnung der Abbildungsoptik zudem derart ausgestaltet und angeordnet, dass sie ein telezentrisches Objektiv auch für die Mehrzahl von Pixeln des Bildsensors bilden. In dieser Ausführungsform ist das telezentrische Objektiv doppelt-telezentrisch.

In einer Ausführungsform der Erfindung liegen eine Brennebene der Abbildungsoptik und eine Fourierebene der Abbildungsoptik in der Austrittsöffnung, wobei die Austrittsöffnung derart ausgestaltet ist, dass die Austrittsöffnung für die Abfragestrahlung ein Hochpassfilter im Fourierraum bildet.

Eine Wechselwirkung der Abfragestrahlung mit dem magnetfeldsensitiven Medium führt dazu, dass die von dem digitalen Bildsensor erfasste Abfragestrahlung zu behandeln ist wie Streustrahlung, d.h. die präzedierenden Atome bilden Streuzentren. Daher tragen im Fourierraum nur höhere räumliche Frequenzen die Information über die Larmorfrequenz. Filtert man mit einer als Hochpass ausgestalteten Austrittsöffnung die niedrigeren Frequenzen heraus, so erhöht sich das Signal-zu Rauschverhältnis der Intensitätsmodulation der Abfragestrahlung aufgrund der Präzession auf dem digitalen Bildsensor.

In einer Ausführungsform der Erfindung ist die Austrittsöffnung kreisringförmig. In einer weiteren Ausführungsform weist die Austrittsöffnung eine Kreisform auf mit einer in der Mitte des Kreises angeordneten Filternadel.

In einer Ausführungsform der Erfindung ist auch die Beleuchtungsoptik derart ausgestaltet und angeordnet, dass eine Fläche der Eintrittsöffnung kleiner ist als die Messfläche des magnetfeldsensitiven Mediums.

In einer Ausführungsform der Erfindung weist die Beleuchtungsoptik eine erste Linsenanordnung und eine zweite Linsenanordnung auf, wobei die erste Linsenanordnung außerhalb des abgeschirmten Volumens angeordnet ist, wobei die zweite Linsenanordnung innerhalb des abgeschirmten Volumens angeordnet ist und wobei die erste Linsenanordnung und die zweite Linsenanordnung derart ausgestaltet und angeordnet sind, dass sie ein telezentrisches Objektiv für eine Austrittsblende der Strahlungsquelle bilden.

Auf diese Weise kann auch die Fläche der Eintrittsöffnung minimiert werden.

In einer Ausführungsform der Erfindung sind die erste Linsenanordnung der Abbildungsoptik und die zweite Linsenanordnung der Beleuchtungsoptik dieselbe Linsenanordnung. Auf diese Weise lässt sich ein raum- und kostensparendes System realisieren.

Gemäß einer Ausführungsform der vorliegenden Erfindung ist innerhalb des abgeschirmten Volumens ein Strahlteiler angeordnet, der die Pumpstrahlung auf die Messfläche ablenkt und die Abfragestrahlung auf die zweidimensionale Anordnung der Mehrzahl von Pixeln des Bildsensors durchlässt oder umgekehrt. Die Strahlachsen der Pumpstrahlung und der Abfragestrahlung können so senkrecht zu der Messfläche justiert sein. In einer Ausführungsform der Erfindung sind die Strahlachsen der Pumpstrahlung und der Abfragestrahlung senkrecht zu der Messfläche justiert.

In einer Ausführungsform der Erfindung ist der Strahlteiler ein polarisierender Strahlteiler, wobei die Pumpstrahlung und die Abfragestrahlung in der Strahlrichtung vor dem Strahlteiler einen definierten Polarisationszustand aufweisen und wobei in der Strahlrichtung der Pumpstrahlung nach dem ersten Durchgang durch den Strahlteiler eine Verzögerungsplatte angeordnet ist, sodass an dem Strahlteiler keine Strahlteilung der Pumpstrahlung und der Abfragestrahlung erfolgt.

In einer Ausführungsform der Erfindung ist die magnetische Abschirmung derart ausgestaltet, dass das Erdmagnetfeld in dem abgeschirmten Volumen 10 Mikrotesla oder weniger beträgt.

In einer Ausführungsform der Erfindung weist die magnetische Abschirmung einen Schirmfaktor von 100 in einem Frequenzbereich des magnetischen Felds von DC bis 100 kHz, vorzugsweise in einem Frequenzbereich des Magnetfelds von 1 kHz bis 100 kHz, auf.

Eine derartige magnetische Abschirmung ist notwendig, da die Larmorfrequenz der Spinpräzession von der Summe aller das magnetfeldsensitive Medium durchsetzenden Magnetfelder abhängt. Dabei nimmt die Larmorfrequenz mit der Stärke des Magnetfelds zu. Ohne eine Reduzierung der Einwirkung des Erdmagnetfelds auf das magnetfeldsensitive Medium müsste daher eine Intensitätsmodulation mit einer sehr hohe Modulationsfrequenz zeitaufgelöst erfasst werden, was aufgrund der begrenzten Abtastraten der verfügbaren digitalen Bildsensoren nicht möglich ist.

Eine Herausforderung bei der Messung des magnetischen Streufelds mithilfe des erfindungsgemäßen Systems ist es, dass innerhalb der Abklingzeit der freien Spinpräzession die Larmorfrequenz hinreichend genau bestimmt werden muss, um ein Maß für die magnetische Flussdichte mit der hinreichenden Sensitivität zu erhalten.

Bei einem in der Strahlrichtung der Anregungsstrahlung und der Abfragestrahlung flachen magnetfeldsensitiven Medium liegt die Abklingzeit typischerweise in der Größenordnung von 10 ms. Die Abklingzeit bestimmt die zum Erfassen der Modulationsfrequenz verfügbare Messzeit. Um den Messbereich für Messungen im nicht abgeschirmten Erdmagnetfeld auf 100 Mikrotesla auszudehnen, müssten deshalb Larmorfrequenzen von 350 kHz bis 700 kHz gemessen werden. Nach dem Nyquist-Shannon-Abtasttheorem muss die Abtastrate, d.h. die Frequenz, mit der Werte für die Intensität der Abfragestrahlung an jedem Pixel gemessen werden, doppelt so hoch sein wie die Larmorfrequenz, um diese mit einer hinreichenden Anzahl von Stützstellen bestimmen zu können.

Bei einer typischen Bildrate von 70 kHz bis 140 kHz innerhalb der durch die Abklingzeit bestimmten Messzeit stehen nur etwa 700 bis 1400 Messpunkte zur Verfügung. Schätzt man die Genauigkeit der Frequenzmessung mit der Schrittweite einer schnellen Fouriertransformation (FFT) ab, dann ergibt sich eine Messunsicherheit, die für die zerstörungsfreie Prüfung von Bauteilen anhand der magnetischen Streufelder noch zu hoch ist.

Daher ist in einer Ausführungsform der Erfindung die Steuer- und Auswerteeinrichtung derart eingerichtet, dass die Steuer- und Auswerteeinrichtung in dem Betrieb des Systems die Schritte ausführt

- Erzeugen des Quellensteuersignals derart, dass die Strahlungsquelle das magnetfeldsensitive Medium über einen ersten Pumpzeitraum mit der Pumpstrahlung beleuchtet und über einen an den ersten Pumpzeitraum anschließenden ersten Abfragezeitraum mit der Abfragestrahlung beleuchtet und dass die Strahlungsquelle das magnetfeldsensitive Medium über einen zweiten, an den ersten Abfragezeitraum anschließenden zweiten Pumpzeitraum mit der Pumpstrahlung beleuchtet und über einen an den zweiten Pumpzeitraum anschließenden zweiten Abfragezeitraum mit der Abfragestrahlung beleuchtet,

- Erzeugen eines Gate-Steuersignals, sodass die Mehrzahl von Pixeln zu der Mehrzahl von ersten Abtastzeitpunkten jeweils eine Intensität der Abfragestrahlung erfasst, Erzeugen des Gate-Steuersignals, sodass die Mehrzahl von Pixeln zu der Mehrzahl von zweiten Abtastzeitpunkten jeweils eine Intensität der Abfragestrahlung erfasst, wobei alle aus der Mehrzahl von ersten Abtastzeitpunkten einen zeitlichen Abstand zu einem Ende des ersten Pumpzeitraums haben und alle aus der Mehrzahl von zweiten Abtastzeitpunkten einen zeitlichen Abstand zu einem Ende des zweiten Pumpzeitraums haben,

wobei alle zeitlichen Abstände voneinander verschieden sind.

Diese Art der Abtastung erhöht die Anzahl von Abtastzeitpunkten und damit Stützstellen für die Fouriertransformation zum Auswerten der Larmorfrequenz aus dem zeitabhängigen Intensitätssignal für jedes Pixel. Dies unter der Voraussetzung, dass bei identischen Pumpzeiträumen ein identisches intensitätsmoduliertes Abfragesignal generiert wird.

Dabei ist die Idee dieser Ausführungsform nicht auf einen ersten und einen zweiten Pumpzeitraum und einen ersten und einen zweiten Abtastzeitraum begrenzt, vielmehr können so viele Pumpvorgänge und Abtastvorgänge wie nötig aneinandergereiht und gemeinsam ausgewertet werden.

Das Gate-Steuersignal wird in einer Ausführungsform der Erfindung dazu genutzt, die Strahlungsquelle während der Abtastzeiträume nur zu den Abtastzeitpunkten einzuschalten bzw. die Strahlung auf das magnetfeldsensitive Medium freizugeben. In einer weiteren Ausführungsform weist der Bildsensor einen elektronischen oder mechanischen Verschluss auf, wobei das Gate-Steuersignal ein Verschlusssteuersignal ist und das Verschlusssteuersignal so erzeugt wird, dass der Verschluss des Bildsensors während des ersten Abfragezeitraums zu der Mehrzahl von ersten Abtastzeitpunkten geöffnet ist und der Verschluss des Bildsensors während des zweiten Abfragezeitraums zu der Mehrzahl von zweiten Abtastzeitpunkten geöffnet ist.

Das Verschieben aller zweiten Abtastzeitpunkte gegenüber den ersten Abtastzeitpunkten relativ zum Ende des jeweiligen Pumpzeitraums lässt sich auf eine Reihe von verschiedenen Arten realisieren. In einer Ausführungsform werden alle ersten und zweiten Abtastzeitpunkte individuell bestimmt. In einer Ausführungsform der Erfindung sind alle ersten Abtastzeitpunkte und alle zweiten Abtastzeitpunkte und optional alle weitere Abtastzeitpunkte zeitlich äquidistant mit einer Abtastfrequenz angeordnet und der erste Pumpzeitraum und der zweite Pumpzeitraum und optional jeder weitere Pumpzeitraum sind zeitlich äquidistant mit einer Pumpträgerfrequenz, wobei die Abtastfrequenz kein ganzzahliges Vielfaches der Pumpträgerfrequenz ist. Sind die Abtastfrequenz und die Pumpträgerfrequenz voneinander verschieden, so liegen die ersten und zweiten Abtastzeitpunkte nach jedem Pumpzeitraum und bezogen auf das Ende des jeweiligen Pumpzeitraums an einer anderen zeitlichen Position.

Insbesondere ist es in einer Ausführungsform bei der nacheinander eine Mehrzahl von Abfragezeiträumen zur Auswertung der Larmorfrequenz herangezogen wird, zweckmäßig die freie Spinpräzession bei oder nach Abschluss des jeweiligen Pumpzeitraums durch Anlegen eines Startsignals an die Messzelle anzustoßen. Auf diese Weise kann gewährleistet werden, dass die Phasenlage der freien-Spinpräzession in allen Abfragezeiträumen, die zusammen zum Bestimmen der Larmorfrequenz herangezogen werden, gleich ist.

Weitere Vorteile, Merkmale und Anwendungsmöglichkeiten der vorliegenden Erfindung werden anhand der folgenden Beschreibung von Ausführungsformen und der dazugehörigen Figuren deutlich. In den Figuren sind gleiche Elemente mit identischen Bezugszeichen bezeichnet.

Figur 1    ist eine schematische Querschnittsansicht eines erfindungsgemäßen Systems zum ortsaufgelösten Erfassen eines Maßes für die magnetische Flussdichte eines magnetischen Streufelds an der Oberfläche eines Prüfobjekts.

Figur 2 ist eine schematische Querschnittsansicht einer alternativen Ausführungsform der Austrittsöffnung aus Figur 1.

Figur 3 ist eine Auftragung der Signalabtastung eines Pixels der Kamera aus Figur 1.

Figur 4 ist eine Auftragung der Auswertung der Larmorfrequenz aus dem abgetasteten Signal aus Figur 3.

Um Änderungen der lokale Spannungskonzentrationen durch Defekte im Vorfeld der Rissbildung sowie Risse 2 selbst in einem ferromagnetischen Prüfobjekt 3 in einem magnetischen Streufeld 4 an einer Oberfläche 5 eines Prüfobjekts 3 messen zu können, müssen auf einer Länge $d_0$ von 0,1 bis 1 mm Unterschiede zwischen der Streufeldverteilung $\vec{B}_S(x, y)$ und dem Streufeld $\vec{B}_D$ eines Defektes wie z.B. eines Risses im Material im Bereich von 1 nT und darunter aufgelöst werden. Das ist mit einem optischen Magnetometer möglich. Dieses Magnetometer umfasst in der dargestellten Ausführungsform einen Pumplaser 6 als Strahlungsquelle, einen in einer Messzelle 7 aufgenommenen Dampf mit Rubidium-Atomen 8 als magnetfeldsensitivem Medium, eine magnetische Abschirmung 9 mit einem abgeschirmten Volumen 10, eine Beleuchtungsoptik 11, einen dielektrischen Spiegel 12, eine CCD-Kamera 13 als digitalen Bildsensor, eine Abbildungsoptik 14 sowie eine Steuer- und Auswerteinrichtung 15.

Das System 1 ermöglicht es, die großflächige Messzelle 7, die in einem Messabstand $d_M$ von der Oberfläche 5 des Prüfobjekts 3 positioniert ist, mit der CCD-Kamera 13 mit einer Vielzahl von matrixförmig angeordneten Bildpunkten BP(i,j) gleichzeitig und ohne scannendes oder abtastendes Element auszulesen. Auf diese Weise erhält man einen kleine, kompakte und hochempfindliche Magnetfeldkamera, die für 1000 oder mehr Bildpunkte BP(i, j) nur einen einzigen Pumplaser 6 und eine einzige Messzelle 7 benötigt.

In der Magnetfeldmessung wird die magnetische Ortsauflösung $d_0$ an der Oberfläche 5 durch den Abstand $d_M$ zwischen der Oberfläche 5 und der Messebene 16 bestimmt, die - entsprechend dem Nyquist-Kriterium - in Abständen $\Delta x$, $\Delta y < d_M/2 \approx d_0/2$ ausgelesen werden muss. Wenn man Störeinflüsse vernachlässigt, dann stellt der Abstand $d_M$ zwischen der Oberfläche 5 und der Messebene 16 physikalisch einen Tiefpassfilter für das magnetische Streufeld $\vec{B}_S(x, y)$ an der Oberfläche 5 des Prüfobjekts 3 dar. Um eine möglichst kurze Prüfzeit pro Prüfobjekt zu erhalten, soll in der Messebene 16 ein möglichst großes Messfeld von beispielsweise $100 \times 100$ mm$^2$ in Abständen $\Delta x$, $\Delta y$ von 0,1 mm vermessen werden. D.h., man benötigt ein Messverfahren mit einer sub-nT-Empfindlichkeit, das flächig $1000 \times 1000 = 1$ Mio Messpunkte auf der Oberfläche 5 des Prüfobjekts 3 gleichzeitig vermessen kann.

Das System 1 löst diese Messaufgabe, indem das Magnetfeld in der Messezelle 7, die die Messebene 16 umfasst, in der CCD-Kamera 13 vermessen wird. Die Messzelle 7 wird möglichst nahe an der zu messenden Oberfläche 5 positioniert und gegen Störeinflüsse wie das Erdmagnetfeld und die Störfelder der Umgebung abgeschirmt. Damit das Streufeld 4, die Messzelle 7 durchsetzen kann, weist die magnetische Abschirmung 9 eine Magnetfeldöffnung 19 auf. Zu den möglichen Störfeldern tragen wesentlich die elektronischen Komponenten des Systems 1 selbst bei, insbe-sondere die CCD-Kamera 13 mit ihrem Störfeld $\vec{B}_K$ und der Laser 6 mit seinem Störfeld $\vec{B}_L$

Daher sind sowohl der Laser 6 als auch die CCD-Kamera 13 mit einem elektronischen Verschluss 17 außerhalb einer magnetischen Abschirmung 9 aus einem Mu-Metall positioniert. Eine Austrittsöffnung $w_S$ durch die Abschirmung 9 in Kombination mit einer telezentrischen Anordnung einer Abbildungsoptik 14 mit einer ersten Linsenanordnung L2 und einer zweiten Linsenanordnung L3 zum Auslesen der Messebene 16 verwendet. Dadurch können in einer Messfläche $w_P$ der Messzelle 7 Bildpunkten BP(i,j) in eine Kamerafläche $w_K$ auf dem Chip der CCD-Kamera 13 zugeordnet werden.

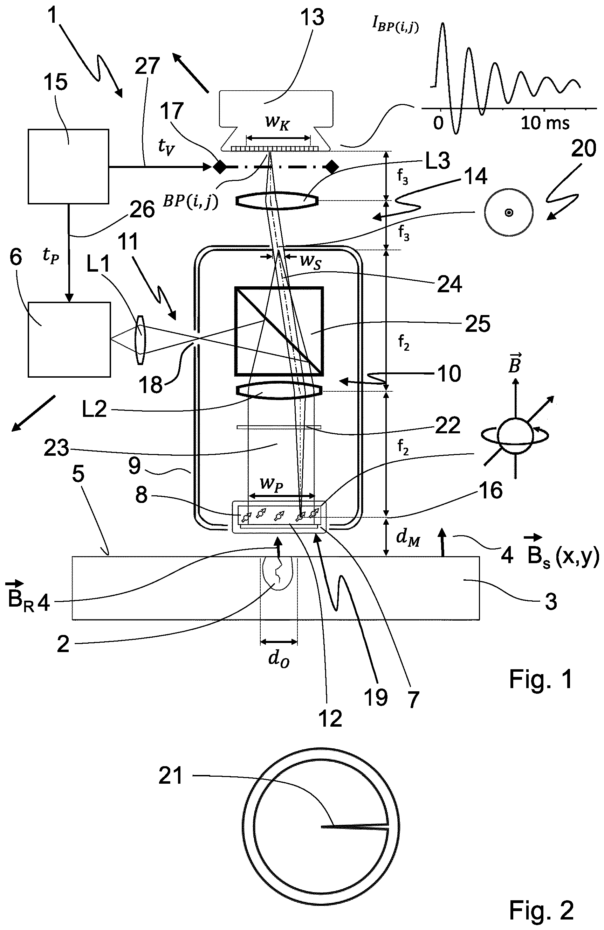

Die magnetische Abschirmung 9 dient als optische Blende sowohl für eine Pumpstrahlung 23 und Abfragestrahlung 24 im Strahlengang von dem Laser 6 zu der Messezelle 7 als auch für den Strahlengang der Abfragestrahlung von der Messezelle 7 zu der CCD-Kamera 13. Da der Laser 13 sehr gut fokussiert werden kann, wird der Durchmesser der Eintrittsblende mit einem Zwischenfokus in einer Eintrittsöffnung 18 der magnetischen Abschirmung 9 minimiert. Figur 1 zeigt ein Beispiel mit einer Beleuchtungsoptik 11 mit einer ersten Linsenanordnung L1 und einer zweiten Linsenanordnung L2 für den Strahlengang von dem Laser 6 zu der Messezelle 7. Dabei ist die zweite Linsenanordnung L2 der Beleuchtungsoptik 11 gleichzeitig auch die erste Linsenanordnung der Abbildungsoptik 14. Die erste Linsenanordnung L1 der der Beleuchtungsoptik 11 erzeugt einen Zwischenfokus in der Eintrittsöffnung 18 der magnetischen Abschirmung 9. Der Strahlengang der Beleuchtungsoptik 11 ist auf der Seite der Messezelle 7 telezentrisch, denn der Durchtritt durch die magnetische Abschirmung 9 erfolgt auf einer optischen Weglänge, die gleich der Brennweite $f_2$ der zweiten Linsenanordnung L2 der Beleuchtungsoptik ist. Dadurch trifft die Pumpstrahlung 23 auf einer Messfläche mit dem Durchmesser $w_L$ senkrecht auf die Messzelle 7.

Zusätzlich sind sowohl die Kamerafläche $w_K$ als auch die Messfläche $w_P$ größer als eine Fläche der Austrittsöffnung $w_S$ der Abschirmung 9. Gleichzeitig wird der große Gleichanteil (siehe I$_{C(i,j)}$ in Figur 2) des gemessenen Intensitätssignals durch die Austrittsöffnung $w_S$ im Fourierraum herausgefiltert und gelangt nicht mehr zur CCD-Kamera 13. Zu diesem Zweck ist die wie in der Einblendung 20 aus Figur 1 angedeutet, die Austrittsöffnung $w_S$ kreisringförmig ausgestaltet. Alterativ ist es möglich, die niedrigen räumlichen Frequenzen mit einer bis in die Mitte einer kreisförmigen Austrittsöffnung $w_S$ ragenden Nadel 21 zu filtern.

Eine λ/4-Platte 22 wird benötigt, um die linear polarisierte Pumpstrahlung 23 und Abfragestrahlung 24 des Lasers 6 in Strahlrichtung nach einem polarisierenden Strahlteiler 25 in zirkular polarisiertes Licht polarisiertes Licht umzuwandeln, um gezielt für die freie Spinpräzession geeignete Energieniveaus der Rubidium-Atome zu pumpen. In der Abtast- oder Messphase, die auf die Pumpphase folgt, wird die Laserleistung reduziert. Die Pumpstrahlung 23 und die Abtaststrahlung 24, so wie sie von dem Laser 6 erzeugt werden, unterscheiden sich in der dargestellten Ausführungsform nur durch ihre Leistung und den Zeitraum ihrer Abstrahlung.

Die Abfragestrahlung 24 wird dann mit sich mit der Larmorfrequenz $\omega_L$ periodisch änderndem Absorptions-koeffizienten in den Rubidiumatomen in der Messzelle 7 absorbiert und als zirkular polarisiertes Licht zur CCD-Kamera 13 zurückgestreut. Diese zirkulare Polarisation wird mit dem Durchtritt durch die λ/4-Platte 22 in linear polarisiertes Licht umgewandelt, dessen Polarisationsebene gegenüber dem von dem Laser 6 kommenden Licht um 90° gedreht ist. Auf diese Weise kommt es an dem Strahlteiler 25 zu keinen Verlusten; das Licht durchläuft den Strahlteiler 25 vollständig in Richtung der CCD-Kamera 13.

Der Laser 6 wird von einer Mess- und Auswerteeinrichtung 26 über ein Quellensteuersignal 26 gesteuert. Der Verschluss 17 der CCD-Kamera 13 wird von der Mess- und Auswerteeinrichtung 26 über ein Gate-Steuersignal 27 gesteuert. Dabei sind das Quellensteuersignal 26 und das Gate-Steuersignal 27 zueinander synchronisiert, so dass innerhalb der Periode n in einem Pumpzeitraum $t_{P,n} < t < t_{FSP,n}$ die Spins des Puffergases gepumpt oder präpariert und in einem Abtastzeitraum $t_{FSP,n} < t < t_{P,n+1}$ die magnetische Feldstärkeverteilung $\vec{B}_S(x, y)$ in der Messfläche anhand der Larmorfrequenz $\omega_L$ aus der Gleichung

$$\omega_L = 2\pi/\tau_L = \gamma B \qquad\qquad\qquad (1)$$

gemessen werden kann, wobei $\gamma$ das für das magnetfeldsensitive Medium 8 spezifische gyromagnetische Verhältnis, B der Betrag der magnetischen Feldstärke und $\tau_L$ die Periodendauer der Larmorfrequenz bezeichnen.

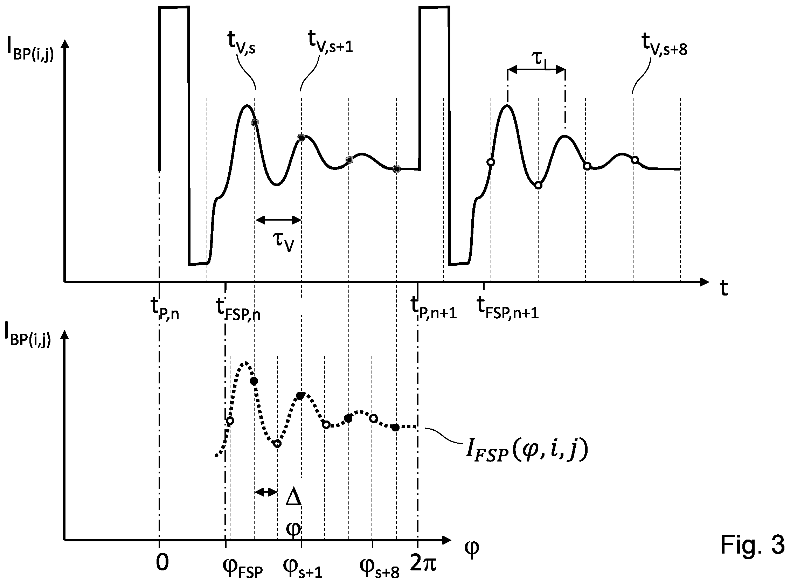

Figur 3 zeigt oben einen typischen Intensitätsverlauf $I_{BP(i,j)}$ der Abfragestrahlung 24 eines Bildpunkt BP(i, j) auf der CCD-Kamera 13 für zwei aufeinanderfolgender Signalperioden n und n+1. In den Pumpzeiträumen $t_{P,n} < t < t_{FSP,n}$ und $t_{P,n+1} < t < t_{FSP,n+1}$ pumpt der Laser 6 mit hoher Leistung die Rubidium-Atome 8 in der Messzelle 7 mit der Pumpstrahlung 23. In den Abfragezeiträumen $t_{FSP,n} < t < t_{P,n+1}$ und $t > t_{FSP,n+1}$, also während der Messphase, erkennt man die gedämpfte Sinusschwingung aufgrund der mit der Larmorfrequenz modulierten Absorption der Abfragestrahlung 14 in den Rubidium-Atomen 8. Während der Messphasen wird die Larmorfrequenz $\omega_L$ gemessen und anhand von Gleichung (1) in eine magnetische Feldstärke $\vec{B}_S(x, y)$ in der Messebene umgerechnet. Die Messzeit - und somit auch die Genauigkeit der Larmorfrequenz- und magnetischen Feldstärkemessung - wird physikalisch durch die Abklingzeit $\tau_{FSP}$ begrenzt. Da die CCD-Kamera 13 aufgrund der begrenzten Datenübertragungsrate nur eine vergleichsweise niedrige Bildrate hat, kann das Abtastintervall $\tau_V = f_V^{-1}$ zwischen zwei Abtastzeitpunkten oder Bildaufnahmen nicht beliebig kurz gewählt werden, was sich wiederum negativ auf die Messgenauigkeit auswirkt.

Um die Messgenauigkeit der Frequenzmessung in jedem einzelnen Messpunkt BP(i,j) zu verbessern, werden daher die Trigger $t_V$ aus dem Gate-Steuersignal 27 für den Verschluss 17 der CCD-Kamera 13 und die Trigger $t_P$ aus dem Quellensteuersignal 26 für den Laser 6 so gegeneinander verstimmt, dass sich die Abtastzeitpunkte $t_{V,s}$ über p Perioden hinweg um den Betrag $\Delta\varphi = \tau_V/p$ relativ zu dem Lasertrigger $t_{P,n}$ und damit zu dem Ende des jeweiligen Pumpzeitraums $t_{P,n} < t < t_{FSP,n}$ und $t_{P,n+1} < t < t_{FSP,n+1}$, in der s-te Abtastzeitpunkt $t_{V,s}$ fällt, verschiebt. Daher ist die Bildrate, also die Abtastfrequenz des Triggers $t_V$, kein ganzzahliges Vielfaches der Pumptriggerfrequenz des Triggers $t_P$ ist.

In dem Beispiel aus Figur 2 ist das Verhältnis $t_V/t_P$ gleich 11/2, wodurch die Abtastzeitpunkte für das Signal $I_{BP(i,j)}$ in dem zweiten Abtastzeitraum um $\Delta\varphi = \tau_V/2$ verschoben sind. Die Abtastzeitpunkte der beiden Abtastzeiträume $t_{FSP,n} < t < t_{P,n+1}$ und $t > t_{FSP,n+1}$, die in die Messphase fallen, werden gemeinsam zur Auswertung der Larmorfrequenz $\omega_L$ verwendet. Dies ist in Figur 2 unten schematisch dargestellt.

Die Abtastzeitpunkte $t_{V,s}$, aus den aufeinanderfolgenden Abtastzeiträumen $t_{FSP,n} < t < t_{P,n+1}$ und $t > t_{FSP,n+1}$ werden in ein einziges Phasenbild zurückgefaltet, an das dann die Funktion $I_{BP}(\varphi, i, j)$ angepasst werden kann (gepunktete Linie). Die schwarzen Messpunkte im unteren Diagramm aus Figur 2 markieren die Abtastzeitpunktepunkte aus dem Abtastzeitraum n, die hohlen Messpunkte die dem Abtastzeitraum n n+1 aus dem oberen Diagramm aus Figur 2.

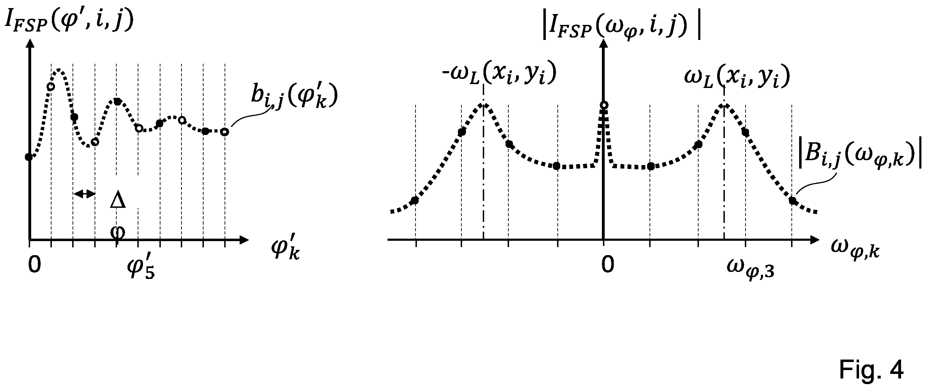

Figur 4 zeigt ein mögliches Verfahren, wie die zweidimensionale, aus mehreren Perioden in das Phasenbild abgebildete Information aus den einzelnen Kamerabildern aus Figur 2 für jeden Bildpunkt vorteilhaft im Sinne einer möglichst schnellen und genauen Messung der Larmorfrequenz $\omega_L$ und somit der magnetischen Feldstärke $\vec{B}_S(x, y)$ ausgenutzt werden kann. Dazu wird eine Grafikkarte ("Graphics Processing Units", GPU) eingesetzt, die eine schnelle Fouriertransformation ermöglicht. Die Berechnung erfolgt in folgenden Schritten:

1. Die Messpunkte $b_{i,j}(\varphi)$ für den für jeden Bildpunkt zu bestimmenden Intensitätsverlauf $I_{FSP}(\varphi, i, j)$ müssen so aufbereitet werden, dass die Fouriertransformierten der Phase $\varphi_k$, nämlich die Ortsfrequenzen $\omega_{\varphi,k}$, die Larmorfre-quenz $\omega_L$ korrekt wiedergeben. Dafür ist es vorteilhaft, den Nullpunkt der Phasenpunkte $\varphi_S$ zu verschieben und den Index s aus Figur 2 auf die Schrittweite $\Delta\varphi$ anzupassen: $\varphi'_k = k\,\Delta\varphi - \varphi_0$ mit $\varphi_0 \approx \varphi_{FSP}$. Das Ergebnis sind die Koeffizienten $b_{i,j}(\varphi'_k)$, die der gemessenen Intensität einzelner Bildpunkte $BP(i, j)$ in Kamerabildern entsprechen. Alternativ kann der effektive Zeitpunkt $\varphi_{FSP}$, ab dem die Spins frei präzedieren, kalibriert werden.

2. Aus den zeitbasierten Koeffizienten $b_{i,j}(\varphi'_k)$ werden die entsprechenden, komplexwertigen Fourierkoeffizienten

$$B_{i,j}(\omega_{\varphi,k}) = FFT(b_{i,j}(\varphi'_k))$$ bestimmt.

3. Zur genauen Bestimmung der Larmorfrequenzen $\omega_L(i, j)$ für jeden Bildpunkt BP(i, j)der Kamera wird an die Fourierkoeffizienten $B_{i,j}(\omega_{\varphi,k})$ ein Modell angepasst, das aus der Fouriertransformierten des exponentiell abfallenden FSP-Signals $I_{BP}(t, i, j)$ erstellt werden kann. Die Fouriertransformierte $I_{FSP}(\omega_\varphi, i, j)$ weist - wie in der gestrichelten Linie in Figur 3 rechts angedeutet - bei der Larmorfrequenz $\omega_L$ ein charakteristisches Maximum im Betrag auf. Der Verlauf von $I_{FSP}(\omega_\varphi, i, j)$ um das Maximum $\omega_L$ kann beispielsweise durch ein polynomielles Modell genähert werden, das numerisch an die Fourierkoeffizienten $B_{i,j}(\omega_{\varphi,k})$ mit dem höchsten Betrag gefittet wird.

4. Zur Verbesserung der Genauigkeit können zur Bestimmung der Larmorfrequenzen $\omega_L(i, j)$ nicht nur die Fourierkoeffizienten $B_{i,j}(\omega_{\varphi,k})$ des jeweiligen Bildpunktes BP(i, j), sondern auch die Koeffizienten aus der Nachbarschaft herangezogen werden.

5. Auch für eine Anpassung des Modells $I_{FSP}(\varphi, i, j)$ im Ortsraum ermöglicht die Kamera-basierte Messung ein Heranziehen der Koeffizienten $b_{i,j}(\varphi'_k)$ aus der jeweiligen Nachbarschaft zur Verbesserung der Messunsicherheit für die Larmorfrequenz $\omega_L(i, j)$ an einem Bildpunkt BP(i,j).

6. Die Zuordnung des jeweiligen Bildpunktes BP(i,j) zu einer Position $(x_i, y_i)$ in der Messebene erfolgt anhand des Abbildungsstrahlengangs durch die Linsen L2 und L3 in Figur 1.

7. Das Auswerteergebnis ist eine bildhafte Anordnung von Larmorfrequenzen $\omega_L$ für jede Position $(x_i, y_i)$ in der Messebene 16 aus Figur 1, die anhand von Gleichung 1 in eine magnetische Feldstärke umgerechnet werden kann. Diese wird zur zerstörungsfreien Prüfung des Bauteils ausgewertet.

8. Da der Abstand $d_M$ zwischen der Oberfläche 5 des Prüfobjekts 3 und der Messebene 16 physikalisch einen Tiefpassfilter für die Feldstärkeverteilung $\vec{B}_S(x, y)$ darstellt, kann die Erkennungssicherheit für Materialdefekte verbessert werden, indem Methoden der Bildverarbeitung wie z.B. Faltungs- oder Entfaltungsoperationen auf die in Figur 4 gezeigten Koeffizienten angewendet werden.

Für Zwecke der ursprünglichen Offenbarung wird darauf hingewiesen, dass sämtliche Merkmale, wie sie sich aus der vorliegenden Beschreibung, den Zeichnungen und den Ansprüchen für einen Fachmann erschließen, auch wenn sie konkret nur im Zusammenhang mit bestimmten weiteren Merkmalen beschrieben wurden, sowohl einzeln als auch in beliebigen Zusammenstellungen mit anderen der hier offenbarten Merkmale oder Merkmalsgruppen kombinierbar sind, soweit dies nicht ausdrücklich ausgeschlossen wurde oder technische Gegebenheiten derartige Kombinationen unmöglich oder sinnlos machen. Auf die umfassende, explizite Darstellung sämtlicher denkbarer Merkmalskombinationen wird hier nur der Kürze und der Lesbarkeit der Beschreibung wegen verzichtet.

Während die Erfindung im Detail in den Zeichnungen und der vorangehenden Beschreibung dargestellt und beschrieben wurde, erfolgt diese Darstellung und Beschreibung lediglich beispielhaft und ist nicht als Beschränkung des Schutzbereichs gedacht, so wie er durch die Ansprüche definiert wird. Die Erfindung ist nicht auf die offenbarten Ausführungsformen beschränkt.

Abwandlungen der offenbarten Ausführungsformen sind für den Fachmann aus den Zeichnungen, der Beschreibung und den beigefügten Ansprüchen offensichtlich. In den Ansprüchen schließt das Wort "aufweisen" nicht andere Elemente oder Schritte aus, und der unbestimmte Artikel "eine" oder "ein" schließt eine Mehrzahl nicht aus. Die bloße Tatsache, dass bestimmte Merkmale in unterschiedlichen Ansprüchen beansprucht sind, schließt ihre Kombination nicht aus. Bezugszeichen in den Ansprüchen sind nicht als Beschränkung des Schutzbereichs gedacht.

**Bezugszeichenliste**

1    System
2    Riss
3    Prüfobjekt
4    magnetisches Streufeld
5    Oberfläche

6     Laser
7     Messzelle
8     Rubidium
9     magnetische Abschirmung
10    abgeschirmtes Volumen
11    Beleuchtungsoptik
12    dielektrischer Spiegel
13    CCD-Kamera
14    Abbildungsoptik
15    Steuer- und Auswerteinrichtung
16    Messebene
17    Verschluss
18    Eintrittsöffnung
19    Magnetfeldöffnung
20    Einblendung
21    Nadel
22    $\lambda/4$-Platte
23    Pumpstrahlung
24    Abfragestrahlung
25    polarisierendender Strahlteiler
26    Quellensteuersignal
27    Gate-Steuersignal

$d_0$      magnetische Ortsauflösung
$\vec{B}_S(x, y)$   Streufeldverteilung
$BP(i, j)$   Bildpunkt
$d_M$     Messabstand
$w_S$     Austrittsöffnung
$w_K$     Kamerafläche
$w_P$     Messfläche
L1     erste Linsenanordnung der Beleuchtungsoptik
L2     erste Linsenanordnung der Abbildungsoptik und zweite Linsenanordnung der Beleuchtungsoptik
L3     zweite Linsenanordnung der Abbildungsoptik

## Patentansprüche

1. System (1) zum ortsaufgelösten Erfassen eines Maßes für die magnetische Flussdichte eines magnetischen Streufelds (4) an der Oberfläche (5) eines Prüfobjekts (3), wobei das System (1) aufweist

    eine Strahlungsquelle (6),
    wobei die Strahlungsquelle (6) derart ausgestaltet und angeordnet ist, dass die Strahlungsquelle (6) in dem Betrieb des Systems (1) elektromagnetische Pumpstrahlung (23) und elektromagnetische Abfragestrahlung (24) erzeugt und abstrahlt,
    ein magnetfeldsensitives Medium (8),
    wobei das magnetfeldsensitive Medium (8) derart ausgestaltet ist, dass es in dem Betrieb des Systems (1) nach optischem Pumpen mit der Pumpstrahlung (23) eine Spinpräzession mit einer von dem Streufeld abhängigen Larmorfrequenz ermöglicht,
    eine magnetische Abschirmung (9) mit einem abgeschirmten Volumen (10), einer Eintrittsöffnung (18) für die Pumpstrahlung (23) und die Abfragestrahlung (24) in das abgeschirmte Volumen (10), einer Austrittsöffnung ($w_S$) für die Abfragestrahlung aus dem abgeschirmten Volumen (10) und einer Magnetfeldöffnung (19) für das Streufeld,

        wobei die Strahlungsquelle (6) außerhalb des abgeschirmten Volumens (10) angeordnet ist und
        wobei das magnetfeldsensitive Medium (8) innerhalb des abgeschirmten Volumens (10) angeordnet ist, so dass das Streufeld (4) in dem Betrieb des Systems (1) das magnetfeldsensitive Medium (8) durchsetzen kann,

    eine Beleuchtungsoptik (11),

wobei die Beleuchtungsoptik (11) derart ausgestaltet und angeordnet ist,
dass sie in dem Betrieb des Systems (1) eine Messfläche des magnetfeldsensitiven Mediums (8) mit der Pumpstrahlung (23) und der Abfragestrahlung (24) beleuchtet,

ein reflektierendes Element (12),
wobei das reflektierende Element (12) derart in einer Strahlrichtung der Abfragestrahlung (24) hinter dem magnetfeldsensitiven Medium (8) angeordnet ist, dass das reflektierende Element (12) die Abfragestrahlung (24) zurück in das magnetfeldsensitive Medium (8) und durch die Austrittsöffnung ($w_S$) aus dem abgeschirmten Volumen (10) reflektiert,
einen digitalen Bildsensor (13) mit

einer Mehrzahl von Pixeln,
einer mit der Mehrzahl von Pixeln verbundenen Ausleseelektronik,
einem mit der Ausleseelektronik verbundenen Analog-Digital-Umsetzer und einem Signalausgang,
wobei der digitale Bildsensor (13) derart eingerichtet ist, dass in dem Betrieb des Systems (1) an dem Signalausgang ein digitales Bildsignal ausgegeben wird, und
wobei der Bildsensor (13) außerhalb des abgeschirmten Volumens (10) angeordnet ist,

eine Abbildungsoptik (14),
wobei die Abbildungsoptik (14) derart ausgestaltet und angeordnet ist, dass die Abbildungsoptik (14) in dem Betrieb des Systems (1) die Abfragestrahlung (24) von jedem aus einer Mehrzahl von Objektpunkten in der Messfläche ($w_P$) durch die Austrittsöffnung ($w_S$) auf jeweils ein Pixel des Bildsensors (13) abbildet, und
eine Steuer- und Auswerteeinrichtung (15),

wobei die Steuer- und Auswerteeinrichtung (15) derart wirksam mit der Strahlungsquelle (6) verbunden ist, dass die Strahlungsquelle (6) in dem Betrieb des Systems (1) ein Quellensteuersignal (26) von der Steuer- und Auswerteeinrichtung (15) empfängt,
wobei die Steuer- und Auswerteeinrichtung (15) derart wirksam mit dem Signalausgang verbunden ist, dass die Steuer- und Auswerteeinrichtung (15) in dem Betrieb des Systems (1) das Bildsignal von dem Bildsensor (13) empfängt,
wobei die Steuer- und Auswerteeinrichtung (15) derart eingerichtet ist, dass die Steuer- und Auswerteeinrichtung (15) in dem Betrieb des Systems (1) die Schritte ausführt

Erzeugen des Quellensteuersignals (26) derart, dass die Strahlungsquelle (6) das magnetfeldsensitive Medium (8) über einen Pumpzeitraum mit der Pumpstrahlung (23) mit einer Pumpintensität beleuchtet und über einen an den Pumpzeitraum anschließenden Abfragezeitraum mit der Abfragestrahlung (24) mit einer Abfrageintensität beleuchtet,
während des Abfragezeitraums für jeden aus der Mehrzahl von Pixeln Berechnen der Larmorfrequenz des zu dem jeweiligen Pixel gehörenden Objektpunkts aus einem zeitlichen Verlauf des Bildsignals und Ausgeben der Larmorfrequenz für jedes Pixel als das Maß für das magnetische Streufeld (4) des Prüfobjekts (3).

2. System (1) nach dem vorgehenden Anspruch, wobei die Abbildungsoptik (14) derart ausgestaltet und angeordnet ist, dass eine Fläche der Austrittsöffnung ($w_S$) sowohl kleiner ist als eine Fläche der Mehrzahl von Pixeln des Bildsensors (13) als auch kleiner ist als die Messfläche ($w_P$).

3. System (1) nach einem der vorhergehenden Ansprüche, wobei die Abbildungsoptik (14) eine erste Linsenanordnung (L2) und eine zweite Linsenanordnung (L3) aufweist,

wobei die erste Linsenanordnung (L2) in der Strahlrichtung der Abfragestrahlung (24) nach dem magnetfeldsensitiven Medium (8) und innerhalb des abgeschirmten Volumens (10) angeordnet ist,
wobei die zweite Linsenanordnung (L3) in der Strahlrichtung der Abfragestrahlung (24) nach der erste Linsenanordnung (L2) und außerhalb des abgeschirmten Volumens (10) angeordnet ist, und
wobei die erste Linsenanordnung (L2) und die zweite Linsenanordnung (L3) derart ausgestaltet und angeordnet sind, dass sie ein telezentrisches Objektiv für die Messfläche ($w_P$) bilden.

4. System (1) nach dem vorhergehenden Anspruch, wobei die erste Linsenanordnung (L2) und die zweite Linsenanordnung (L3) der Abbildungsoptik (14) derart ausgestaltet und angeordnet sind, dass sie ein telezentrisches Objektiv für die Mehrzahl von Pixeln des Bildsensors (13) bilden.

5. System (1) nach einem der Ansprüche 2 bis 4, wobei eine Brennebene der Abbildungsoptik und eine Fourierebene der Abbildungsoptik in der Austrittsöffnung liegen, wobei die Austrittsöffnung derart ausgestaltet ist, dass die Austrittsöffnung ein Hochpassfilter im Fourierraum bildet.

6. System (1) nach einem der vorhergehenden Ansprüche, wobei die Beleuchtungsoptik (11) derart ausgestaltet und angeordnet ist, dass eine Fläche der Eintrittsöffnung (18) kleiner ist als die Messfläche ($w_P$).

7. System (1) nach einem der vorhergehenden Ansprüche, wobei die Beleuchtungsoptik (11) eine erste Linsenanordnung (L1) und eine zweite Linsenanordnung (L2) aufweist,

wobei die erste Linsenanordnung (L1) außerhalb des abgeschirmten Volumens (10) angeordnet ist,
wobei die zweite Linsenanordnung (L2) innerhalb des abgeschirmten Volumens (10) angeordnet ist, und
wobei die erste Linsenanordnung (L1) und die zweite Linsenanordnung (L2) derart ausgestaltet und angeordnet sind, dass sie ein telezentrisches Objektiv für eine Austrittsblende der Strahlungsquelle bilden.

8. System (1) nach einem der vorhergehenden Ansprüche soweit von den Ansprüchen 3 und 7 abhängig, wobei die erste Linsenanordnung (L2) der Abbildungsoptik (14) und die zweite Linsenanordnung (L2) der Beleuchtungsoptik (11) dieselbe Linsenanordnung sind.

9. System (1) nach einem der vorhergehenden Ansprüche, wobei innerhalb des abgeschirmten Volumens (10) ein Strahlteiler (25) angeordnet ist, der die Pumpstrahlung (23) auf die Messfläche ($w_P$) ablenkt und die Abfragestrahlung (24) auf die zweidimensionale Anordnung der Mehrzahl von Pixeln des Bildsensors (13) durchlässt oder umgekehrt.

10. System (1) nach dem vorhergehenden Anspruch, wobei der Strahlteiler (25) ein polarisierender Strahlteiler ist, wobei die Pumpstrahlung (23) und die Abfragestrahlung (24) einen definierten Polarisationszustand aufweisen und wobei in der Strahlrichtung der Pumpstrahlung (23) nach dem ersten Durchgang durch den Strahlteiler (25) eine Verzögerungsplatte (22) angeordnet ist, so dass an dem Strahlteiler (25) keine Strahlteilung der Pumpstrahlung (23) und der Abfragestrahlung (24) erfolgt.

11. System (1) nach einem der vorhergehenden Ansprüche, wobei die magnetische Abschirmung (9) derart ausgestaltet ist, dass das Erdmagnetfeld in dem abgeschirmten Volumen (10) 10 Mikrotesla oder weniger beträgt.

12. System (1) nach einem der vorhergehenden Ansprüche,
wobei die Steuer- und Auswerteeinrichtung (15) derart eingerichtet ist, dass die die Steuer- und Auswerteeinrichtung (15) in dem Betrieb des Systems (1) die Schritte ausführt

Erzeugen des Quellensteuersignals derart, dass die Strahlungsquelle (6) das magnetfeldsensitive Medium (8) über einen ersten Pumpzeitraum mit der Pumpstrahlung (23) beleuchtet und über einen an den ersten Pumpzeitraum anschließenden ersten Abfragezeitraum mit der Abfragestrahlung beleuchtet und dass die Strahlungsquelle (6) das magnetfeldsensitive Medium (8) über einen zweiten an den ersten Abfragezeitraum anschließenden zweiten Pumpzeitraum mit der Pumpstrahlung (23) beleuchtet und über einen an den zweiten Pumpzeitraum anschließenden zweiten Abfragezeitraum mit der Abfragestrahlung beleuchtet,
Erzeugen eines Gate-Steuersignals (27), so dass die Mehrzahl von Pixeln zu der Mehrzahl von ersten Abtastzeitpunkten jeweils eine Intensität der Abfragestrahlung (24) erfasst,
Erzeugen des Gate-Steuersignals (27), so dass die Mehrzahl von Pixeln zu der Mehrzahl von zweiten Abtastzeitpunkten jeweils eine Intensität der Abfragestrahlung (24) erfasst,
wobei alle aus der Mehrzahl von ersten Abtastzeitpunkten einen zeitlichen Abstand zu einem Ende des ersten Pumpzeitraums haben und alle aus der Mehrzahl von zweiten Abtastzeitpunkten einen zeitlichen Abstand zu einem Ende des zweiten Pumpzeitraums haben, wobei alle zeitlichen Abstände voneinander verschieden sind.

13. System (1) nach dem vorhergehenden Anspruch, wobei alle ersten Abtastzeitpunkte und alle zweiten Abtastzeitpunkte und optional alle weiteren Abtastzeitpunkte zeitlich äquidistant mit einer Abtastfrequenz angeordnet sind und der erste Pumpzeitraum und der zweite Pumpzeitraum und optional jeder weitere Pumpzeitraum zeitlich äquidistant mit einer Pumptriggerfrequenz sind, wobei die Abtastfrequenz kein ganzzahliges Vielfaches der Pumptriggerfrequenz ist.

**14.** System (1) nach einem der vorhergehenden Ansprüche, wobei das magnetfeldsensitive Medium (8) ein Gas oder ein Dampf ist.

**15.** System (1) nach dem vorhergehenden Anspruch, wobei das Gas oder der Dampf in einer Messzelle (7) aufgenommen ist, wobei die Messzelle vorzugsweise beheizbar ist und vorzugsweise in der Strahlrichtung der Abfragestrahlung eine Dicke von 500 Mikrometern oder weniger aufweist.

Fig. 1

Fig. 2

Fig. 3

EP 4 644 889 A1

Fig. 4

Nummer der Anmeldung

EP 24 17 3848

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | WO 2020/106957 A1 (UNIV COLORADO REGENTS [US]; OKADA YOSHIO [US]) 28. Mai 2020 (2020-05-28) * das ganze Dokument * | 1-15 | INV. G01N24/00 G01R33/26 |
| A | KOSS PETER A. ET AL: "Optically Pumped Magnetometer Measuring Fatigue-Induced Damage in Steel", APPLIED SCIENCES, Bd. 12, Nr. 3, 26. Januar 2022 (2022-01-26), Seite 1329, XP093133393, ISSN: 2076-3417, DOI: 10.3390/app12031329 * das ganze Dokument * | 1-15 | |
| A | BAI XUANYAO ET AL: "Atomic magnetometers and their application in industry", FRONTIERS IN PHYSICS, Bd. 11, 8. Juni 2023 (2023-06-08), XP093208685, ISSN: 2296-424X, DOI: 10.3389/fphy.2023.1212368 * das ganze Dokument * | 1-15 | |

| RECHERCHIERTE SACHGEBIETE (IPC) |
|---|
| G01N G01R |

Der vorliegende Recherchenbericht wurde für alle Patentansprüche erstellt

| Recherchenort | Abschlußdatum der Recherche | Prüfer |
|---|---|---|
| München | 30. September 2024 | Skalla, Jörg |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
.................................................................
& : Mitglied der gleichen Patentfamilie, übereinstimmendes
Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 24 17 3848

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-09-2024

| Im Recherchenbericht angeführtes Patentdokument | Datum der Veröffentlichung | Mitglied(er) der Patentfamilie | Datum der Veröffentlichung |
|---|---|---|---|
| WO 2020106957 A1 | 28-05-2020 | US 2022011386 A1 | 13-01-2022 |
| | | WO 2020106957 A1 | 28-05-2020 |

EPO FORM P0461

Für nähere Einzelheiten zu diesem Anhang : siehe Amtsblatt des Europäischen Patentamts, Nr.12/82